# FASCICULE DE BREVET EUROPEEN

(11) **EP 1 489 665 B1**
(45) Date de publication et mention de la délivrance du brevet: **12.10.2016**
(21) Numéro de dépôt: 04291495.2
(22) Date de dépôt: 15.06.2004
(51) Int. Cl.: H01L 31/024, H01L 31/02

(54) **Photodétecteur refroidi**
Gekühlter Photodetektor
Cooled Photodetector

(30) Priorité: 20.06.2003 FR 0307481
(43) Date de publication de la demande: 22.12.2004
(73) Titulaire: SAGEM Défense Sécurité, 75015 Paris (FR)
(72) Inventeur: Coursaget, Francois, 78150 Le Chesnay (FR)
(74) Mandataire: Gevers & Orès

(56) Documents cités:
- EP-A- 0 493 208
- EP-A- 0 899 795
- US-A- 4 488 414
- US-A- 4 995 236
- US-A- 5 198 671
- US-A- 5 382 797
- PATENT ABSTRACTS OF JAPAN vol. 018, no. 618 (P-1831), 24 novembre 1994 (1994-11-24) -& JP 06 235657 A (NIKON CORP), 23 août 1994 (1994-08-23)

## Description

La présente invention concerne les photodétecteurs refroidis, photodétecteurs thermiques ou photodétecteurs quantiques.

Il sera dans la suite utilisé le terme de photodétecteur. Un photodétecteur est généralement constitué d'un ou plusieurs capteur(s) monté(s) sur une table froide, refroidie par un refroidisseur.

Dans le cas d'applications nécessitant un refroidissement très rapide, comme par exemple dans l'utilisation de photodétecteurs dans les engins autopropulsés et téléguidés, on utilise un refroidisseur du type à détente de Joule-Thomson, dans lequel un gaz se détend en sortie d'un gicleur et atteint sa température minimale à l'équilibre entre les phases solides et liquides. Ce refroidisseur permet de refroidir la table, et doit pour ce faire vaincre l'inertie thermique de cette dernière.

De plus, les capteurs du photodétecteur doivent être mis à l'abri des rayonnements parasites au moyen d'un écran, solidaire de la table froide, qui doit lui aussi être refroidi et présente également une inertie thermique à vaincre.

Des dispositifs mécaniques ont été proposés afin de permettre le refroidissement de la table froide et de l'écran, tout en assurant l'homogénéité thermique de l'ensemble. Certains dispositifs effectuent ce refroidissement par conduction, mais ce type de refroidissement est trop lent en raison de l'inertie thermique.

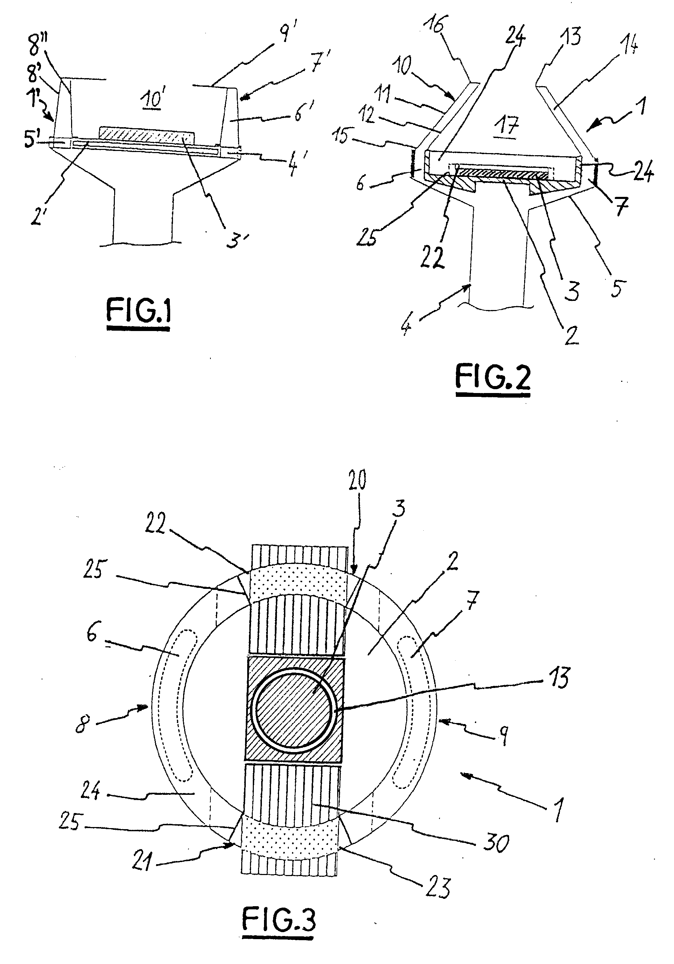

La demande de brevet français déposée par la demanderesse sous le numéro FR 2834127 propose de refroidir à la fois la table et l'écran par convection, en les soumettant au volume de détente du refroidisseur. La figure 1 représente un mode de réalisation d'un tel photodétecteur. Dans ce dispositif 1', une table 2', sur laquelle est placé un capteur 3', est percée d'orifices 4', 5' de passage du flux de refroidissement communiquant avec une cavité annulaire 6' de mise en froid d'un écran 7', la cavité 6' s'étendant entre deux enveloppes cylindriques 8', 8" fixées sur la table 2'. Un rebord annulaire 9' ferme en partie l'espace intérieur 10' à l'enveloppe interne 8" de l'écran, jouant le rôle de diaphragme pour le capteur 3'. En outre, des pistes de connexions électriques sont disposées en couche interne sous l'écran dans l'épaisseur de la table 2'.

La solution proposée permet un refroidissement efficace. La demanderesse a poursuivi les développements afin de remédier à certains inconvénients.

En effet, le placement des pistes de connexions électriques dans les couches internes de la table 2' provoque des interférences électriques conduisant à du bruit sur le signal. Ce placement en couche interne est de surcroît difficile et onéreux à mettre en oeuvre.

Le rebord annulaire 9' placé au sommet de la cavité annulaire 6' est refroidi par conduction, donc plus lentement que le reste du dispositif 1'.

Le montage du photodétecteur n'est pas très simple. Il faut souder les enveloppes cylindriques 8', 8" sur la table 2', puis fixer le(s) capteur(s) 3' sur la table 2', avant de fixer le rebord annulaire 9' au sommet des enveloppes 8', 8", cette opération s'effectuant nécessairement après la fixation du capteur 3', puisque le diamètre intérieur du rebord 9' est plus petit que celui du capteur 3'. Ainsi, il n'est pas possible par exemple de procéder à des tests d'étanchéité sur le photodétecteur 1' sans capteur 3', afin de ne pas l'abîmer, ce dernier ne pouvant être placé dans le dispositif l'en dernière position.

Le document US 4,995,236 décrit un appareil cryostatique pour détecteur de radiation.

La présente invention vise à pallier ces inconvénients.

A cet effet, la présente invention concerne un photodétecteur refroidi comportant une table, au moins un capteur monté sur la table et lié à des pistes de connexions électriques, un écran monté sur la table pour éviter les rayonnements parasites sur le capteur, au moins un refroidisseur Joule-Thomson pour refroidir la table et l'écran, dans lequel la table et l'écran sont refroidis par convexion en étant soumis directement au volume de détente du refroidisseur placé sous la table, la table étant percée d'orifices de passage du flux de refroidissement communiquant avec une cavité de mise en froid de l'écran, caractérisé par le fait que la table comporte sur sa périphérie un épaulement, sur lequel est monté l'écran, un passage pour le capteur et les circuits de connexions électriques étant ménagé dans l'épaulement.

Par épaulement, on entend tout moyen surélevé par rapport au plan où repose le capteur.

De préférence, l'écran comprend deux enveloppes de forme sensiblement tronconique fixées sur l'épaulement de la table, définissant entre elles la cavité de mise en froid de l'écran.

La présente invention sera mieux comprise à l'aide de la description suivante du mode de réalisation préféré de l'invention, en référence au dessin annexé, dans lequel :
- la figure 1 représente une vue schématique en coupe d'un photodétecteur de l'art antérieur ;
- la figure 2 représente une vue schématique en coupe du photodétecteur de l'invention ;
- la figure 3 représente une vue schématique de dessus du photodétecteur de l'invention ;
- la figure 4 représente une vue en perspective du photodétecteur de l'invention, et
- la figure 5 représente une vue en perspective partiellement coupée du photodétecteur de l'invention.

En référence à la figure 2, un photodétecteur 1 comprend généralement un ou plusieurs capteur(s) 3, monté(s) sur une table circulaire 2, refroidie par un refroidisseur de Joule-Thomson 4 monté dans un puits de cryostat (doigt froid) qui se raccorde à la table par une portion tronconique 5 s'élargissant en direction de la table 2. Il sera décrit dans la suite un photodétecteur 1 muni d'un seul capteur 3, la généralisation à plusieurs capteurs étant évidente. Le refroidisseur de Joule-Thomson comporte un serpentin alimenté en gaz à haute pression et terminé par un gicleur d'où le gaz est éjecté ; à l'équilibre entre phase gazeuse et phase liquide, la température minimale est atteinte, la température à atteindre déterminant le choix du gaz. Ce dispositif n'est pas représenté car il est bien connu de l'art antérieur. L'ensemble du photodétecteur 1 est isolé par le vide ou un gaz neutre dans un cryostat non représenté.

En référence aux figures 2 et 3, la table circulaire 2 comporte un épaulement circulaire 24 placé le long de son contour. Cet épaulement 24 est surélevé par rapport à la table d'une hauteur supérieure à celle des pistes de connexions électriques 30 ; on entendra par épaisseur de l'épaulement 24 sa largeur mesurée parallèlement à la table. Dans deux régions 8, 9 diamétralement opposées, l'épaulement 24 est percé dans le sens de la hauteur de deux évents 6, 7 de passage du flux de refroidissement. Deux autres évents 22, 23 sont percés, cette fois dans le sens de l'épaisseur de l'épaulement 24, dans deux régions 20, 21 diamétralement opposées, et décalées de 90° par rapport aux deux régions 8, 9 dans lesquelles sont percés les premiers évents 6, 7 cités. Ces évents 22, 23 permettent le passage du capteur 3 et des pistes de connexions électriques 30 du photodétecteur 1. Les pistes de connexions électriques 30 sont contenues dans un substrat, formant une nappe, sur laquelle le capteur 3 est collé. Selon une autre forme de réalisation, les pistes sont réalisées à l'aide d'une ligne souple connectée directement au capteur 3, se passant alors de la présence du substrat.

Les évents 22, 23 de passage des pistes de connexions électriques 30 comportent des chanfreins 25 permettant de faciliter l'introduction du capteur 3 et des pistes de connexions électriques 30. Si l'ouverture des évents 22, 23 s'avérait trop grande, laissant par conséquent passer des rayons parasites pouvant gêner le bon fonctionnement du photodétecteur 1, il serait possible, une fois le photodétecteur 1 et le capteur 3 montés, de venir placer une couronne de protection autour de la paroi extérieure de la table 2. Il serait également possible d'obturer ces évents 22, 23 avec de la colle ou autre matière.

Grâce aux évents 22, 23 de passage des pistes de connexions électriques 30, le capteur 3 et les pistes de connexions électriques 30 peuvent être mis en place en derniers, une fois le reste du photodétecteur 1 intégralement monté. Il est en particulier possible d'effectuer des tests, d'étanchéité par exemple, sur le photodétecteur 1 sans le capteur 3, en ne risquant donc pas d'endommager ce dernier. La nappe de circuits de connexions électriques 30, sur laquelle est également collé le capteur 3, peut ensuite être introduite dans l'espace intérieur 17 à l'enveloppe interne 12 de l'écran 10, par les évents 22, 23. Le capteur 3 est placé au centre de la table 2. Il est également possible de changer le capteur 3 sans changer le photodétecteur 1.

Conformément à l'autre forme de réalisation évoquée plus haut, on place le capteur 3 directement sur la table 2, par le dessus, avant le montage de l'écran 10 et on câble ensuite le capteur 3 avec les pistes électriques 30 (qui sont des lignes souples), introduites par les évents 22, 23. Cette solution ne permet pas de tester l'étanchéité du photodétecteur sans le capteur 3. En revanche, elle facilite grandement le montage de l'ensemble et permet de réduire la taille des évents 22, 23, limitant ainsi les rayons parasites.

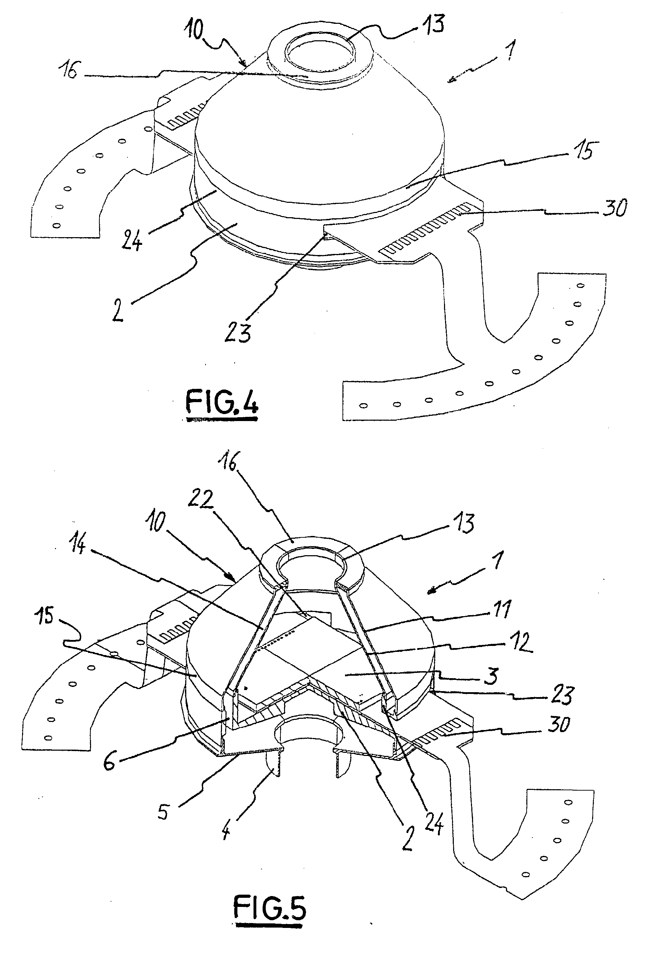

En référence aux figures 4 et 5, sur l'épaulement 24 de la table 2 est monté un écran 10 de protection contre les rayons parasites ; il peut être collé ou soudé sur la table 2, ou encore usiné d'une seule pièce avec la table 2. Cet écran 10 comporte deux enveloppes 11, 12, afin de ménager une cavité 14 de circulation du flux de refroidissement, qui communique avec les évents 6, 7 de passage du flux de refroidissement. La forme des enveloppes 11, 12 de l'écran 10 est telle que l'ouverture 13 du sommet 16 de l'écran 10 soit de dimensions inférieures à celles de la base 15 de l'écran 10, en particulier inférieures aux dimensions du capteur 3. L'écran 10 assure ainsi la fonction de diaphragme optique pour le capteur 3, de par les dimensions de son ouverture 13.

La conformation adoptée permet à l'écran 10, non seulement d'assurer ce rôle de diaphragme optique, mais aussi d'être refroidi par convection, grâce au flux de refroidissement dans la cavité 14 entre les deux enveloppes 11, 12, depuis sa base 15 jusqu'à son sommet 16.

Dans la forme de réalisation préférée du photodétecteur 1 de l'invention, les enveloppes 11, 12 sont de forme tronconique. Cette forme est la plus compacte qui soit pour passer d'un cercle de base 15 à un cercle de sommet 16 plus petit. Cette compacité améliore la mise à froid puisque la masse thermique est plus faible. Cette configuration améliore en outre la montée rapide des gaz vers l'écran 10. La rigidité de cette forme de réalisation lui permet de plus de satisfaire aux exigences vibratoires inhérentes à l'utilisation qui est faite des capteurs.

En fonctionnement, le gaz de refroidissement arrive par le doigt de cryostat. Il se répand alors dans la portion tronconique 5 de raccordement à la table 2, refroidissant de ce fait la table 2, ainsi que dans la cavité 14 de l'écran 10, par les évents 6, 7, assurant de cette façon le refroidissement de l'écran 10. La conformation tronconique de l'écran 10 permet d'avoir un diaphragme 13 placé loin du capteur 3, ce qui est avantageux d'un point de vue optique, le refroidissement efficace de l'écran 10 étant tout de même assuré.

## Revendications

1. Photodétecteur refroidi (1) comportant une table (2), au moins un capteur (3) monté sur la table (2) et lié à des pistes de connexions électriques (30), un écran (10) monté sur la table (2) pour éviter les rayonnements parasites sur le capteur (3), au moins un refroidisseur Joule-Thomson (4) pour refroidir la table (2) et l'écran (10), **caractérisé par le fait que** la table (2) et l'écran (10) sont refroidis par convexion en étant soumis directement au volume de détente du refroidisseur (4) placé sous la table (2), la table (2) étant percée d'orifices (6, 7) de passage du flux de refroidissement communiquant avec une cavité (14) de mise en froid de l'écran (10), la table (2) comporte sur sa périphérie un épaulement (24) sur lequel est monté l'écran (10), un passage (22, 23) pour les circuits de connexions électriques (30) étant ménagé dans l'épaulement (24).

2. Photodétecteur selon la revendication 1, dans lequel le passage (22, 23) permet également le passage du capteur (3).

3. Photodétecteur selon l'une des revendications 1 et 2, dans lequel le passage (22, 23) est constitué de deux ouvertures (22, 23) percées dans l'épaisseur de l'épaulement (24).

4. Photodétecteur selon l'une des revendications 1 à 3, dans lequel l'écran (10) comprend deux enveloppes (11, 12) de forme sensiblement tronconique, fixées sur l'épaulement (24) de la table (2), définissant entre elles la cavité (14) de mise en froid de l'écran (10).

5. Photodétecteur selon l'une des revendications 1 à 4, dans lequel l'écran (10) est usiné d'une seule pièce avec la table (2).

6. Photodétecteur selon l'une des revendications 1 à 5, dans lequel les orifices (6, 7) de passage du flux de refroidissement sont diamétralement opposés.

7. Photodétecteur selon les revendications 3 et 6, dans lequel les ouvertures du passage (22, 23) sont diamétralement opposées et décalées de 90° par rapport aux orifices (6, 7) de passage du flux de refroidissement.

8. Photodétecteur selon l'une des revendications 1 à 7, dans lequel les ouvertures du passage (22, 23) sont chanfreinées (25).

## Patentansprüche

1. Gekühlter Fotodetektor (1) mit einem Tisch (2), wenigstens einem Sensor (3), der auf dem Tisch (2) montiert und mit Leiterbahnen (30) verbunden ist, mit einem Schirm (10), der auf dem Tisch (2) montiert ist, um parasitäre Strahlung auf den Sensor (3) zu vermeiden, mit wenigstens einem Joule-Thomson Kühler (4), um den Tisch (2) und den Schirm (10) zu kühlen, **dadurch gekennzeichnet, dass** der Tisch (2) und der Schirm (10) durch Konvektion gekühlt werden, indem sie direkt dem Entspannungsvolumen des Kühlers (4) ausgesetzt sind, der unter dem Tisch (2) angeordnet ist, dass der Tisch (2) von Durchgangsöffnungen (6,7) für den Kühlungsfluss durchsetzt ist, der mit einem zu kühlenden Hohlraum (14) des Schirmes (10) kommuniziert, dass der Tisch (2) an seinem Rand eine Schulter (24) aufweist, auf welcher der Schirm (10) montiert ist, dass in der Schulter (24) ein Durchlass (22,23) für elektrische Schaltungsanschlüsse (30) vorgesehen ist.

2. Fotodetektor nach Anspruch 1, bei dem der Durchlass (22,23) auch den Durchtritt des Sensors (3) gestattet.

3. Fotodetektor nach einem der Ansprüche 1 und 2, bei dem der Durchlass (22,23) aus zwei Öffnungen (22,23) gebildet ist, welche die Wanddicke der Schulter (24) durchbrechen.

4. Fotodetektor nach einem der Ansprüche 1 bis 3, bei dem der Schirm (10) zwei im Wesentlichen kegelstumpfförmige Hüllen (11,12) aufweist, die auf der Schulter (24) des Tisches (2) befestigt sind und zwischen sich den zu kühlenden Hohlraum (14) des Schirmes (10) begrenzen.

5. Fotodetektor nach einem der Ansprüche 1 bis 4, bei dem der Schirm (10) gemeinsam mit dem Tisch (2) aus einem einzigen Stück hergestellt ist.

6. Fotodetektor nach einem der Ansprüche 1 bis 5, bei dem die Durchgangsöffnungen (6,7) für den Kühlungsfluss einander diametral gegenüberliegen.

7. Fotodetektor nach einem der Ansprüche 3 und 6, bei dem sich die Durchlassöffnungen (22,23) diametral gegenüber liegen und in Bezug auf die Durchgangsöffnungen (6,7) für den Kühlungsfluss um 90° versetzt sind.

8. Fotodetektor nach einem der Ansprüche 1 bis 7, bei dem die Durchlassöffnungen (22,23) angesenkt (25) sind.

## Claims

1. Cooled photodetector (1) comprising a table (2), at least one sensor (3) mounted on table (2) and connected to electrical connection tracks (30), a screen (10) mounted on table (2) to avoid parasitic radiation on the sensor (3), at least one Joule-Thomson cooler (4) to cool the table (2) and the screen (10), **characterised in that** the table (2) and screen (10) are cooled by convection by being directly subjected to the expansion volume of the cooler (4) placed under the table (2), table (2) being pierced with orifices (6,7) for the passage of the cooling flow communicating with a cavity (14) for cooling the screen (10), the table (2) having on its periphery a shoulder (24) on which is mounted the screen (10), a passage (22, 23) for the electrical connection circuits being (30) provided in the shoulder (24).

2. Photodetector according to claim 1, wherein the passage (22, 23) also enables passage of the sensor (3).

3. Photodetector according to one of claims 1 and 2 wherein the passage (22, 23) consists of two openings (22, 23) drilled in the thickness of the shoulder (24).

4. Photodetector according to any one of claims 1 to 3 wherein the screen (10) comprises two envelopes (11, 12) of substantially truncated conical shape, fixed on the shoulder (24) of table (2), defining between them the cavity (14) for cooling the screen (10).

5. Photodetector according to any one of claims 1 to 4, wherein the screen (10) is machined from a single part with the table (2).

6. Photodetector according to any one of claims 1 to 5, wherein orifices (6, 7) for the passage of the cooling flow are diametrically opposed.

7. Photodetector according to claims 3 and 6, wherein the passage openings (22, 23) are diametrically opposed and shifted 90° in relation to the orifices (6, 7) for the passage of the cooling flow.

8. Photodetector according to any one of claims 1 to 7, wherein the passage openings (22, 23) are bevelled (25).
